# EUROPEAN PATENT SPECIFICATION

(11) **EP 2 627 605 B1**
(45) Date of publication and mention of the grant of the patent: **20.12.2017**
(21) Application number: 11769797.9
(22) Date of filing: 12.10.2011
(51) Int. Cl.: B81C 99/00

(54) **PROCESS FOR PRODUCING HIGHLY ORDERED NANOPILLAR OR NANOHOLE STRUCTURES ON LARGE AREAS**
VERFAHREN ZUR HERSTELLING VON HOCH GEORDNETEN NANOSÄULEN- ODER NANOLOCHSTRUKTUREN AUF GROSSEN FLÄCHEN
PROCÉDÉ DE FABRICATION DE STRUCTURES HAUTEMENT ORDONNÉES DE NANOPILIERS OU DE NANOTROUS SUR DE GRANDES SURFACES

(30) Priority: 13.10.2010 EP 10013595
(43) Date of publication of application: 21.08.2013
(73) Proprietor: Max-Planck-Gesellschaft zur Förderung der Wissenschaften e.V., 80539 München (DE); Ernst-Abbe-Hochschule Jena, 07745 Jena (DE)
(72) Inventor: MORHARD, Christoph, 71640 Ludwigsburg (DE); PACHOLSKI, Claudia, 14469 Potsdam (DE); SPATZ, Joachim P., 70569 Stuttgart (DE); BRUNNER, Robert, 07743 Jena (DE)
(74) Representative: Katzameyer, Michael
(86) International application number: PCT/EP2011/005122
(87) International publication number: WO 2012/048870

(56) References cited:
- DE-C1- 19 952 018
- US-A1- 2008 268 288

## Description

### Background of the Invention

Arrays of nanopillars or nanocones on various substrate surfaces gained growing interest in recent years since they can be utilized in a broad range of important industrial applications. For example, these structures can be used as anti-reflective coatings (moth eye effect), the reduction of friction or changing the wetting properties. First approaches for producing such structures concentrated on the use of expensive techniques like e-beam lithography. Nowadays a number of bottom-up approaches have been invented which are based on self-assembly (e.g. Lohmüller, T. et al., in Nano Letters 8, 1429-1433 (2008); Park et al. in ACS Nano 3, no. 9 (2009): 2601-2608). These techniques lead to a decrease of the production costs to a level, which might be low enough to allow commercial launch. However, to date there are still no products commercially available.

As already mentioned, not only the creation of nanopillar arrays is of interest, but also the creation of nanohole arrays. But almost all reports on ordered hole arrays on the sub 150 nm range still use expensive and time consuming lithographic techniques. The only technique existent to date to reproduce nanopatterns at relative reasonable costs is nano imprint lithography. However, as the masters used as stamps in that technique are very expensive and have to be replaced frequently large-scale commercial use for many applications is still limited.

The BCML-techniques disclosed in DE 10 2007 014 538 A1 and DE 10 2009 060 223.2 finally opened up a possibility to a new generation of sophisticated antireflective coatings applied on high-end on optics. Examples for those are high-end camera lenses, medical instruments or nano/microoptical devices. Nevertheless, a large number of mass-produced optical elements exist for example for beamers, cameras in mobile phones or next generation telecommunication, where lenses are used to focus light into optical fibers. The production costs in this "low end" optics have to be very low. Consequently, the material of choice is often a polymer like PMMA. The use of conventional thin film antireflective coatings is difficult on optical elements made of polymers, because the adhesion of antireflective films on polymers is problematic. Therefore the use of alternative antireflection techniques like for example moth eye structuring, as described in Lohmüller, T. et al., in Nano Letters 8, 1429-1433 (2008), is eligible. However, the more important problem is, that conventional antireflective coatings would increase the production costs of the optical elements significantly. This is also the reason, why the technique described in Lohmüller et al. and DE 10 2007 014 538 A1 is not applicable for these very cost sensitive applications. The same arguments hold true for low cost glass optics or nanopillar arrays used for other purposes than antireflective coatings.

The use of a BCML technique to fabricate pillars on fused silica and the subsequent use as master in a NIL process has been described by Park et al. in ACS Nano 3, no. 9 (2009): 2601-2608. However, the process described in this publication is rather complicated and time consuming. In particular it takes several days to provide a substrate nanostructured with nanopillars and the mean distance of the nanopillars is below 20 nm and cannot be adjusted easily to larger distances.

DE 199 52 018 C1 discloses a method for producing a metal nanocluster decorated substrate by a BCML-related technique.

US 2008/0268288 A1 teaches the thin film layer patterning of a substrate by a spinodal process involving reactive ion or chemical etching for the fabrication of nanoislands.

So far there is no method commercially available for the mass production of cost sensitive products with nanopillars /nanocones/nanoholes.

In view of these drawbacks of the methods used in the prior art, the main object of the present invention was to provide improved methods for producing highly ordered nanopillar or nanohole structures, in particular on large areas, which can be used as masters in NIL, hot embossing or injection molding processes, in a simple, fast and cost-efficient manner.

This object has been achieved by providing the methods of claims 1 and 2. Additional aspects and/or specific embodiments of the invention are the subject of further claims.

Claim 1 relates to a method for preparing highly ordered nanohole structures on a substrate surface comprising
a) providing a primary substrate that is decorated on at least one surface with an ordered array of metal nanoparticles produced by means of a micellar blockcopolymer nanolithography process;
b) etching the primary substrate of step a) in a predetermined depth, preferably in the range from 50 to 500 nm, wherein the nanoparticles act as a mask and an ordered array of nanopillars or nanocones corresponding to the positions of the nanoparticles is produced;
c) using the nanostructured substrate obtained in step b) as a master or stamp in nanoimprint lithographic (NIL), hot embossing or injection molding processes.

Claim 2 relates to a method for preparing highly ordered nanohole structures on a substrate surface comprising
a) providing a primary substrate that is decorated on at least one surface with an ordered array of metal nanoparticles produced by means of a micellar blockcopolymer nanolithography process;
b) etching the primary substrate of step a) in a predetermined depth, preferably in the range from 50 to 500 nm, wherein the nanoparticles act as a mask and an ordered array of nanopillars or nanocones corresponding to the positions of the nanoparticles is produced;
c) coating the nanostructured substrate surface obtained in step b) with a continuous metal layer;
d) selective etching of the product of step c) using an etching agent, e.g. HF, which removes the primary substrate but not the metal layer, resulting in a metal substrate comprising an ordered array of nanoholes which is a negative of the original array of nanopillars or nanocones.

The present invention encompasses two principally different approaches to nanostructure surfaces via a cheap replication process.

A first approach involves nanoimprint lithography (NIL). In this technique a resist layer is deposited on a surface and this resist layer is then nanostructured via a stamp. Afterwards the resist is polymerized by UV-radiation or heat. Finally the stamp is removed and a thin, hardened resist layer remains on the surfaces, which can then be further processed by dry etching, sputtering or other methods. This additional step to further process the sample, is not necessary in the techniques described later in this application, but the advantage of NIL is the flexibility regarding the substrate material.

The second approach involves several more direct methods for direct structuring of substrates. For some materials (e.g. plastic, glass) it is possible to structure the samples directly without an additional step. There exist a number of methods, e.g. injection molding, reaction injection molding, hot embossing, injection compression molding, precision molding (glass) and thermoforming. However all those methods are very similar. Therefore, the following discussion distinguishes only between the most different methods, namely hot embossing - where a heated master is pressed into a blank -and injection molding, where liquid plastic is injected into a mold. In the case of glass, hot embossing is called precision molding and this technique gained considerable attention during the last years.

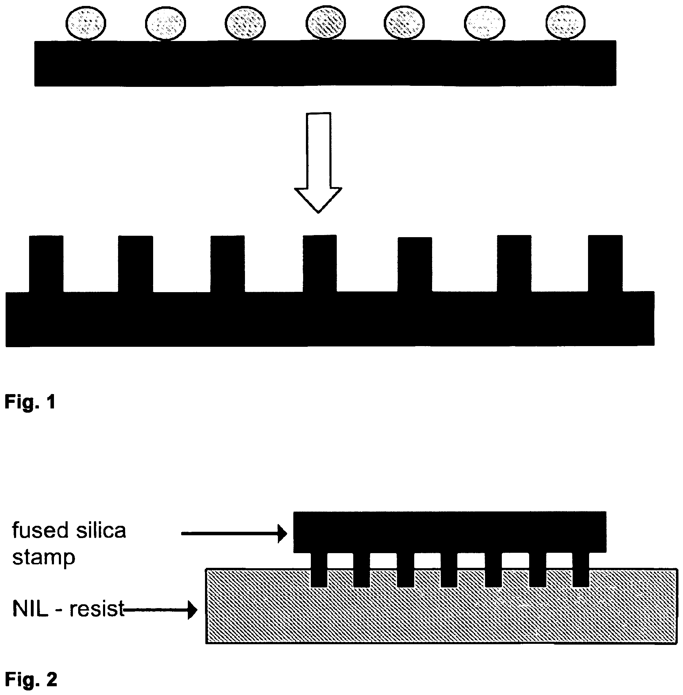

In both approaches, at first a primary substrate has to be nanostructured. The nanopillars/nanocones are fabricated according to the steps in DE 10 2007 014 538 A1 (pillars) or DE 10 2009 060 223.2 (cones) starting from a substrate surface decorated with nanoparticles produced by micellar blockcopolymer nanolithography (schematically depicted in Fig. 1).

### Stamp for NIL

A primary substrate is decorated with nanopillars or nanocones using the methods described above. The nanostructured substrate is not used as optical element (antireflective properties), but as a stamp for a NIL (nanoimprint lithography) process. As the primary substrate, principally any substrate which is suitable for reactive ion etching can be used. More specifically, the substrate is selected from the group consisting of glasses, in particular borosilicate glasses and fused silica, and silicon.

Preferably fused silica is used as the primary substrate. This material is often chosen for commercial available stamps, as it combines a few advantageous features. First, it is transparent for UV-light and therefore allows to initiate the resist hardening (polymerization) process with UV-radiation. Second, it has a small expansion coefficient, which is advantageous if the resist is developed by thermal heating. And third SiO₂ (fused silica) can be easily treated with chemicals containing silane groups to modify the wetting behavior. Usually fused silica is treated with a hydrophobic silane in order to prevent the substrate from gluing to the NIL-resist.

In the methods according to claims 1 or 2 the etching in step b) preferably comprises a reactive ion etching treatment. The etching agent for this treatment may be any etching agent known in the art and suitable to etch the respective primary substrate. More specifically, the etching agent is selected from the group consisting of chlorine, gaseous chlorine compounds, fluoro hydrocarbons, fluorocarbons, oxygen, argon, SF₆, and mixtures thereof.

In a specific embodiment of the inventive methods, the shape of the nanocones essentially corresponds to one half of a hyperboloid.

Such nanocones can be produced by the method disclosed in DE 10 2009 060 223.2 10. This method is characterized in that in the etching step b) the etching parameters are adjusted so that hyperboloid structures are produced and the nanocones are produced by breaking said hyperboloid structures in the region of their smallest diameter by application of mechanical forces, preferably ultrasonication.

In the methods of the invention, the nanoparticles of step a) may be any metal nanoparticles which can be produced by micellar blockcopolymer nanolithography. More specifically, the metal nanoparticles are noble metal nanoparticles such as gold, silver, platinum, preferably gold nanoparticles, or nickel or chromium nanoparticles.

The nanopillars or nanocones of the primary substrate typically have a mean distance of from 20 nm to 400 nm, preferable from 25 nm to 300 nm, more preferred from 50 nm to 250 nm. The methods for producing the same as disclosed in DE 10 2007 014 538 A1 (pillars) or DE 10 2009 060 223.2 (cones) advantageously allow to adjust their spacings and heights conveniently over large ranges in the sub micrometer range.

As evident from Fig. 2, the resist is decorated with holes after the NIL process. The nanostructured resist layer can be used as a mask to produce a hole array in the subjacent substrate (supporting the resist layer) by etching (dry etching process). Ways to create nanopillars out of this hole structure in the resist are either: PVD (physical vapor deposition) and removing the resist afterwards or inverting the structure with another subjacent resist film. Both methods are well established, therefore the creation of either hole or pillar structures with a master, structured with nanopillars, is straightforward.

Nowadays commercially available tools (master stamps) for NIL are very expensive. Depending on the requirements, their price can exceed 10.000 € per piece. This is about a factor 500 more than the price of a master fabricated with the present technique. As the stamps in the NIL-process have to be replaced frequently, reducing the cost of the master stamp significantly reduces production costs.

The present invention provides stamps for the reproduction of pillar- or hole-structures on various materials/surfaces via the NIL technology by a very convenient, fast and efficient process leading to a significant decrease of the production costs.

### Master for hot embossing or injection molding

The NIL method described above is used to pattern a special resist on top of a surface. To transfer this resist pattern into the substrate itself in an additional step (e.g. dry etching) is necessary. Therefore another method is required to structure samples directly, as it would be preferable for cheap mass-produced components. There are two main approaches: Forming a sample by compress molding or by casting. In the case of compress molding one distinguishes usually between hot embossing (used for plastic) and precision molding (used for glass). However the technique is in both cases the same: A heated master is pressed into the mold. Afterwards the master is removed and the replicate is cooled and further processed if necessary.

The other approach is injection molding in which the master is not pressed into a mould, but heated liquid material (usually a polymer) is injected into a master mould. After cooling and hardening, the mould is removed and the sample further processed if necessary.

For both approaches a master is needed which is a negative of the final form. In the case of a convex lens for example one needs a concave master. Furthermore the material of choice for the tool is usually not fused silica, but a metal alloy. This prevents an easy fabrication of the master with our BCML method like described above. Instead additional steps are necessary which are described below. The whole procedure is similar to the LIGA process (Becker et al., Microelectronic Engineering 4, no. 1 (May 1986): 35-56) but no synchrotron radiation is required.

First of all a primary stamp, e.g. a fused silica stamp, is produced as described above with respect to the stamp for NIL.

The obtained nanostructured primary stamp is "seeded" (decorated) with a metal, preferable a hydrofluoric acid resistant and comparatively hard metal like chromium or nickel. This can be achieved in two different ways: Either by using Physical Vapor Deposition (PVD), e.g. sputtering or evaporation, or by binding metal colloids to the fused silica substrate.

Afterwards a metal film is grown by electroless deposition, a method which is in the case of nickel and chromium a well established process widely used in industry. The sample is immersed into a plating solution till the desired film thickness is achieved.

If necessary the thickness of the layer is further increased by electroplating (faster process than electroless plating). If the metal layer is thick enough, the whole sample is bonded to a carrier plate. This carrier plate is also furnished with the appropriate mountings to be placed as master in the injection molding or compress molding equipment.

The metal of said metal layer may be any metal or metal alloy which is resistant to the etching agent used in the subsequent etching step. More specifically, the metal of said metal layer is selected from the group consisting of Ni, Cr or alloys such as Ni-Co.

In the last step, the primary substrate is removed in an etching solution, e.g. a HF-solution for a fused silica or glass substrate.

The nanostructured metal substrate obtained via these steps can be used as a master or stamp in nano imprint lithographic (NIL), hot embossing or injection molding processes for replicating said nanostructure on other substrates.

In a preferred embodiment of the present invention, the final substrate surface nanostructured during said nanoimprint lithographic (NIL), hot embossing or injection molding processes is a non-planar, in particular convex or concave, surface.

More specifically, the final substrate surface nanostructured during said nanoimprint lithographic (NIL), hot embossing or injection molding processes is the surface of an optical element e.g. a window, a lens, a microlens-array, an intraocular lens or a sensor device or a component of a solar cell.

Glass (or fused silica) can be processed by a number of methods to almost arbitrary shape. Prominent examples are very tiny microlense arrays (MLA). As it is also possible to equip almost every topography with nanopillars using the technique described in DE 10 2007 014 538 A1 and DE 10 2009 060 223.21,2,3, a negative master for injection molding or compress molding (hot embossing or precision molding) can be formed for most applications. The fabrication of micropillars on fused microlense arrays has already been shown in the inventors' group. It will be possible to fabricate injection molding tools for MLAs by the methods outlined above as well. Beamers are typical applications, where MLAs are necessary. Light intensity is very important for this application, especially for the emerging class of LED-beamers. Nevertheless, as production costs are a very important factor, most beamer MLAs have no antireflective coating at all. But despite the advantages of an injection molding/ hot embossing/ precision molding process in comparison to directly fabricate nanostructured samples there was no cost effective method to produce molds/stamps which are decorated with ordered nanopillar arrays available until now.

The described basic replication techniques are widely used nowadays and reported in almost countless publications and patents. There are also publications/patents mentioning various production techniques for the tools used in those replication techniques. Electroless deposition and electrodeposition are a standard technique for creating thin layers and micromechanical tools (LIGA-process). In contrast to the original LIGA technique, the present method does not require additional resist and no synchrotron radiation. Another difference is the used substrate material: glasses or fused silica instead of PMMA. In conclusion: the present invention provides the use of pillar/cone patterned fused silica samples fabricated by the method described above not as antireflective coatings, but as NIL masters or tools for hot embossing respectively injection molding. This would be - to the best of the inventors' knowledge - the first stamp/tool production process which is fast and cheap enough for commercial applications.

The invention is further illustrated by the following nonlimiting Examples and Figures.

### FIGURES

**Fig. 1****.** Schematic drawing showing the process for fabricating nanopillars on primary substrates by micellar blockcopolymer nanolithography.
**Fig. 2****.** Schematic drawing showing the use of a fused silica sample with a nanopillar array on top as a stamp for a NIL-process.
**Fig. 3****.** Schematic drawing showing the preparation of a nanostructured metal tool for hot-embossing and injection molding.
**3a.** Schematic drawing showing a fused silica sample with nanopillars on top.
**3b.** Schematic drawing showing the nanopillar array after being seeded with a thin metal layer or colloids.
**3c.** Schematic drawing showing the pillar array from Fig. 3b, but after the thin metal layer has been grown to a continuous film via electroless deposition.
**3d.** Schematic drawing showing the complete tool bonded to a carrier plate and equipped with the appropriate mountings.
**3e.** Schematic drawing showing the finished tool.

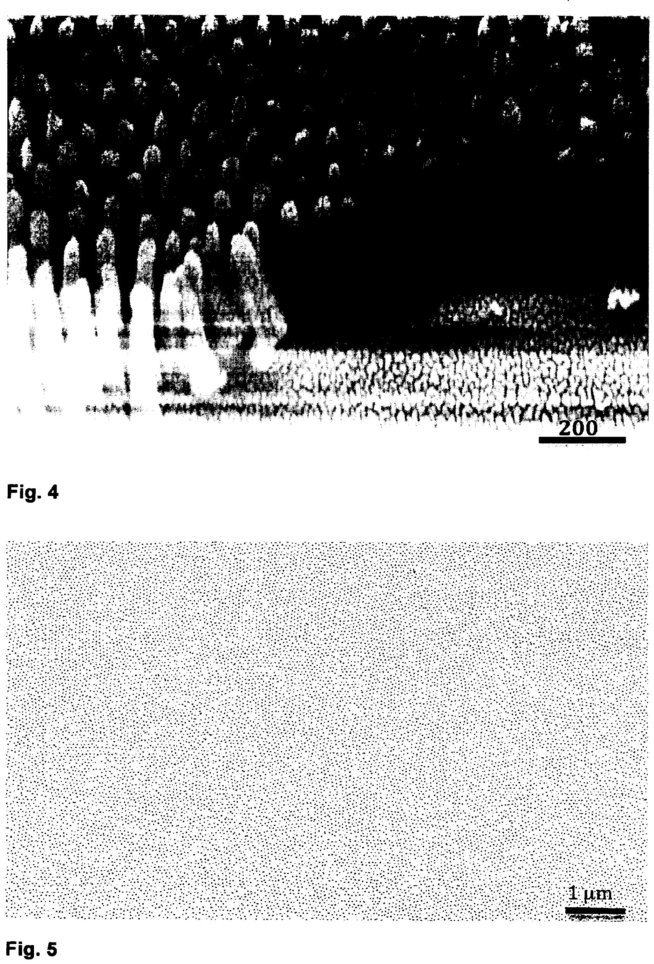

**Fig. 4****.** SEM image of pillar structures (height approx. 250nm) on a fused silica sample. The image is taken at a viewing angle of 45° and the surface has been scratched with a diamond tip to show the shape of the pillars more clearly.
**Fig. 5****.** An electron micrograph showing a plastic foil in which a sample like in Fig. 1, but with lower pillar height has been pressed. The structure is replicated over a large are and the former pillar array is transformed into a hole array.

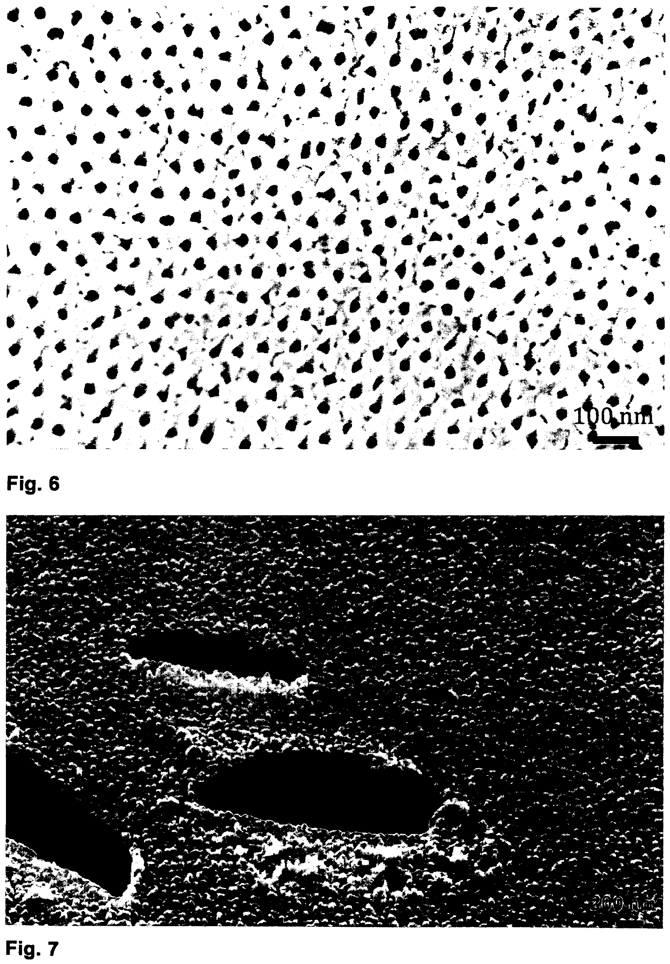

**Fig. 6****.** An electron micrograph of the same sample as in Fig. 5 but taken with higher magnification. The hole formation due to the impressed nanopillars is clearly visible.

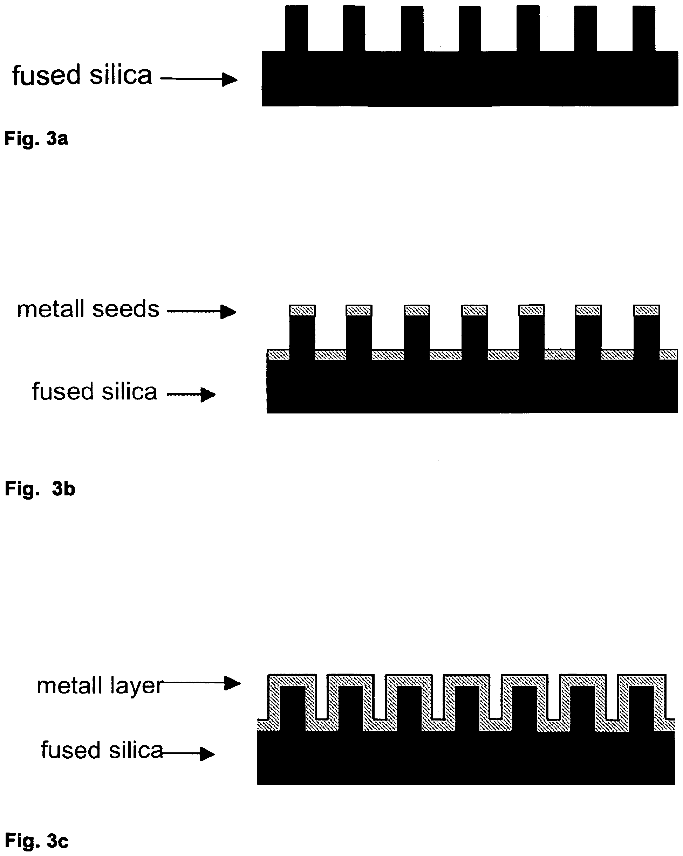

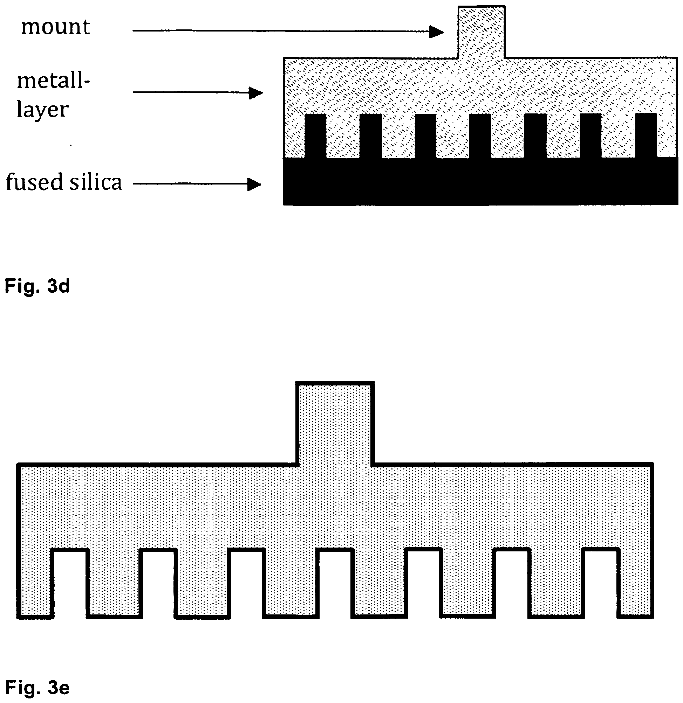

**Fig. 7****.** SEM image of a polymer sheet in which a stamp with higher nanopillars has been pressed. Despite the height of the pillars, the production process is the same as in Fig. 2 and Fig. 3. The viewing angle is 45°, the defects are due to contaminations with dust during the imprint process.

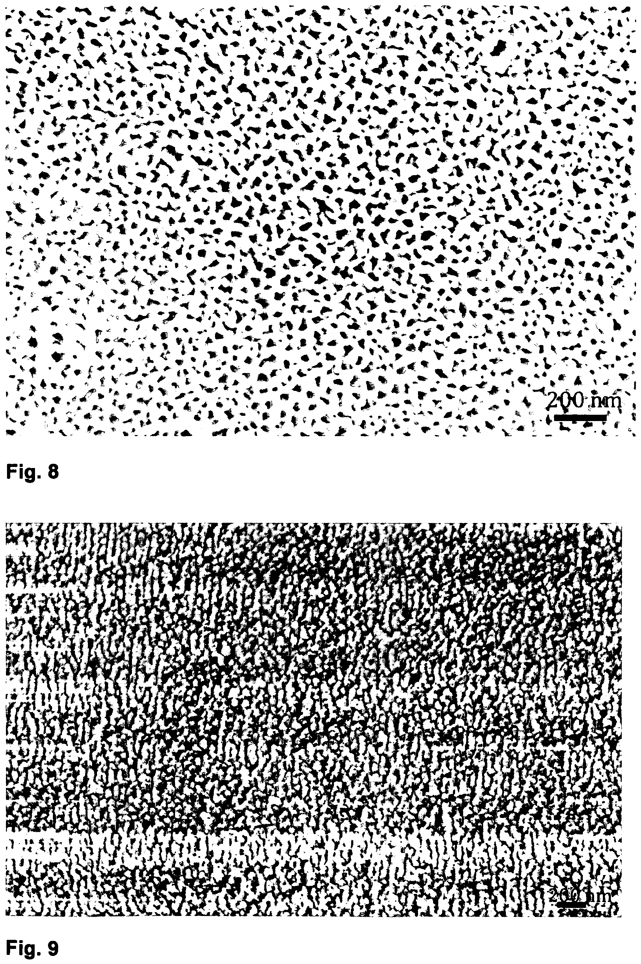

**Fig. 8****.** Top-view SEM image of the sample shown in Fig. 7.
**Fig. 9****.** An electron micrograph of a fused silica sample after it has been pressed into a polymer sheet to produce the structures shown in Figs. 7 and 8. The pillar structures remain intact. Viewing angle is 45 degrees.

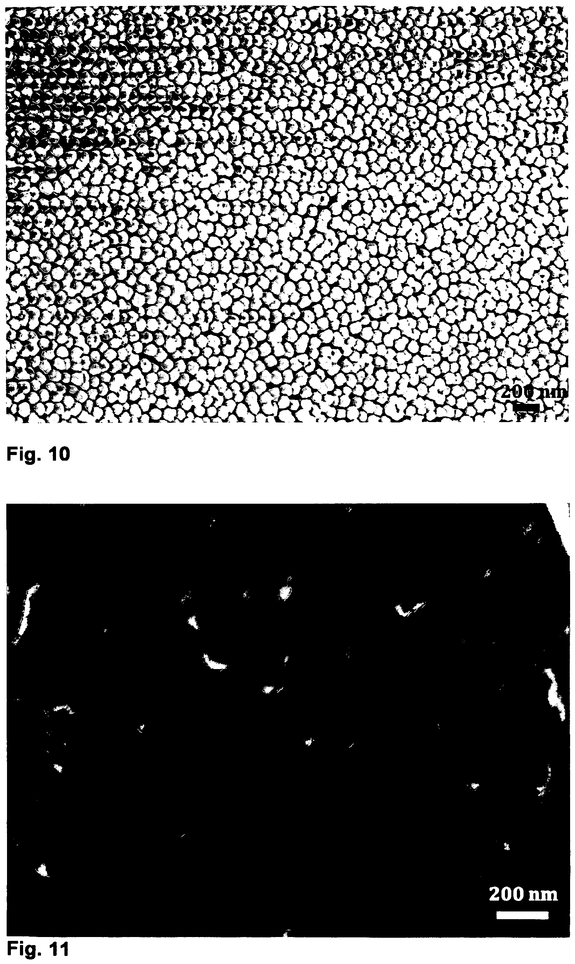

**Fig. 10****.** An electron micrograph taken at 25° viewing angle of a pillar-structure similar to the one shown in Fig. 4, but coated with a thin gold layer via sputtering. As expected, it is not possible to form a closed film with sputtering only (due to the topography of the sample).
**Fig. 11****.** An electron micrograph of the same sample as in Fig. 10, but after electroless gold deposition. A thick film is created, covering the pillar structures completely.

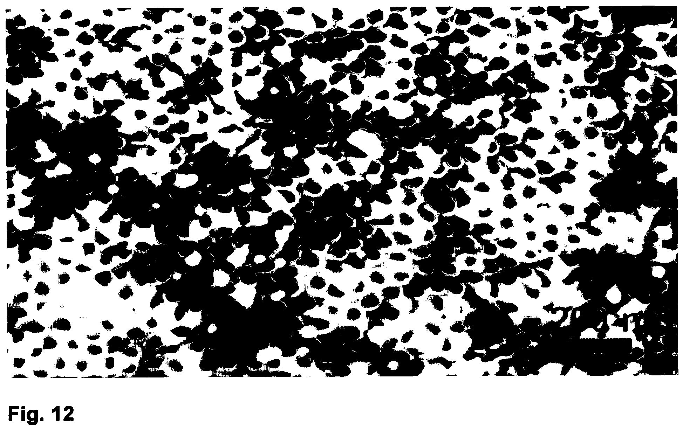

**Fig. 12****.** The gold metal film on the opposite side of Fig. 11, after the glass has been removed via hydrofluoric acid. The pillar structure of the glass has been transferred into the metal. Using this structure as a mold or as a stamp would result in a sample, which is furnished with pillars like the original sample in Fig. 4.

### EXAMPLE 1

### Preparation and characterization of a master for NIL/embossing processes

The suitability of the samples decorated with nanopillars/nanocones as described above for use as masters for a NIL/embossing process has been verified by the following test: A NIL device was used and one of the samples pressed into a plastic film. This plastic film is used in an intermediate step in a special NIL process by the company Obducat and available for the public.

This plastic film serves as model system for the feasibility of embossing, as described with respect to the second approach in the general part above. Two different kinds of nanopillar arrays were tested: one with smaller pillars and one with slightly higher pillars. A SEM image of this (higher) fused silica nanopillar stamp is presented in Fig. 4.

The fused silica masters were pressed into a plastic film via a NIL-process. For that purpose a flat fused silica master, decorated with nanopillars (essentially according to the method of DE 10 2007 014 538 A1) has been used. The distance between individual pillars was about 80 nm and the height between about 100 nm and 250 nm respectively. Prior to the NIL-process the master has been treated with a silane (3-aminopropyltriethoxysilane) deposited in an evaporation process to reduce adhesion between master and sample. Utilization of the master with the smaller pillars leads to the formation of regularly ordered holes (Fig. 5,6), whereas the master with the higher structures reproduced other nanostructures (Fig. 7,8). To verify that the pillar structures are not destroyed on the master in the transfer process and the master can be used more than once, scanning electron micrograph images of the NIL-stamp were taken after it had been pressed into the plastic film. The pillar structure remains intact (Fig. 9).

### EXAMPLE 2

### Preparation and testing of a metal master for injection molding or compress molding processes

Successful fabrication of a tool for an injection molding or compress molding process was proven by the following experiments. First, a fused silica sample decorated with nanopillars or nanocones was fabricated by micellar blockcopolymer nanolithography (essentially as described in DE 10 2007 014 538 A1 or DE 10 2009 060 223.2). The resulting pillar distance was about 80 nm and pillar height about 250 nm. Subsequently, this sample has been coated with a thin gold layer of about 50 nm by sputtering (Fig. 10) for about 120 sec in a commercially available tool (Baltec MSC01). Here, gold instead of nickel or chromium was used since gold is easier to deposit via electroless deposition.

Afterwards this layer was grown further via electroless deposition (Fig. 11). For that purpose the sample has been exposed to a 1 mM solution of HAuCl₄ in water. The electroless deposition has been started by the reducing agent hydroxylamine hydrochloride. The whole deposition process lasted about 1 h. The resulting film is a little bit rough as it is usually the case in electroless deposition. If this turns out to be a problem, the film can be smoothened with an additional annealing step. The next step in the described process would be bonding to a carrier-plate. To fasten the procedure, that step was skipped and the gold covered sample bonded to a HF-resistant epoxide to conduct the proof-of-concept experiment. Finally the sample was etched in 40% HF at room temperature for about 12h to remove the SiO₂ and the remaining metal structure is shown in Fig. 12. The structure shown here is the realization of the last step described to produce injection molding tools (Fig. 3e). The resulting structure is a negative of the original pillar structures.

## Claims

1. A method for preparing highly ordered nanohole structures on a substrate surface by nanoimprint lithographic (NIL), hot embossing or injection molding processes comprising
a) providing a primary substrate that is decorated on at least one surface with an ordered array of metal nanoparticles produced by means of a micellar blockcopolymer nanolithography process;
b) etching the primary substrate of step a) in a predetermined depth, preferably in the range from 50 to 500 nm, wherein the nanoparticles act as a mask and an ordered array of nanopillars or nanocones corresponding to the positions of the nanoparticles is produced;
c) using the nanostructured substrate obtained in step b) which comprises an ordered array of nanopillars or nanocones as a master or stamp to produce a corresponding negative structure on a secondary substrate.

2. A method for preparing highly ordered nanohole structures on a substrate surface comprising
a) providing a primary substrate that is decorated on at least one surface with an ordered array of metal nanoparticles produced by means of a micellar blockcopolymer nanolithography process;
b) etching the primary substrate of step a) in a predetermined depth, preferably in the range from 50 to 500 nm, wherein the nanoparticles act as a mask and an ordered array of nanopillars or nanocones corresponding to the positions of the nanoparticles is produced;
c)coating the nanostructured substrate surface obtained in step b) with a continuous metal layer;
d) selective etching of the product of step c) using an etching agent, e.g. HF, which removes the primary substrate but not the metal layer, resulting in a metal substrate comprising an ordered array of nanoholes which is a negative of the original array of nanopillars or nanocones.

3. The method according to claim 2, wherein the coating of the primary substrate with a continuous metal layer in step c) is effected by i) applying an initial metal film (seed layer) by physical vapor deposition (PVD), e.g sputtering or evaporation, or binding of metal colloids, ii) growing the metal film by electroless deposition or electroplating until a predetermined final thickness of the metal layer is reached.

4. The method according to claim 2 or 3, wherein the metal of said metal layer is selected from the group consisting of Ni, Cr or alloys such as Ni-Co.

5. The method according to claims 2-4, which further comprises using the nanostructured metal substrate obtained in step d) which comprises an ordered array of nanoholes as a master or stamp to produce a corresponding negative structure on a secondary substrate by nanoimprint lithographic (NIL), hot embossing or injection molding processes.

6. The method according to any one of claims 1-5, wherein the primary substrate is selected from the group consisting of glasses, in particular borosilicate glasses and fused silica, and silicon.

7. The method according to any one of claims 1-6, wherein the etching in step b) comprises a reactive ion etching treatment.

8. The method according to claim 7, wherein the etching in step b) comprises a treatment with an etching agent which is selected from the group consisting of chlorine, gaseous chlorine compounds, fluoro hydrocarbons, fluorocarbons, oxygen, argon, SF₆, and mixtures thereof.

9. The method according to any one of claims 1-8, wherein the shape of the nanocones essentially corresponds to one half of a hyperboloid.

10. The method according to claim 9, wherein in the etching step b) hyperboloid structures are produced and the nanocones are produced by breaking said hyperboloid structures in the region of their smallest diameter by application of mechanical forces, in particular ultrasonication.

11. The method according to any one of claims 1-10, wherein the nanoparticles are noble metal, in particular gold, Ni or Cr nanoparticles.

12. The method according to any one of claims 1-11, wherein the nanopillars or nanocones have a mean distance of from 20 nm to 400 nm, preferable from 25 nm to 300 nm, more preferred from 50 nm to 250 nm.

13. The method according to any one of claims 1-12, wherein the final substrate surface nanostructured during said nanoimprint lithographic (NIL), hot embossing or injection molding processes is a non-planar, in particular convex or concave, surface.

14. The method according to any one of claims 1-13, wherein the final substrate surface nanostructured during said nanoimprint lithographic (NIL), hot embossing or injection molding processes is the surface of an optical element e.g. a window, a lens, a microlens-array, an intraocular lens or a sensor device or a component of a solar cell.

## Patentansprüche

1. Verfahren zur Herstellung von hochgeordneten Nanohole-Strukturen auf einer Substratoberfläche durch Nanoimprint-Lithografie(NIL)-Verfahren, Heißprägeverfahren oder Spritzgussverfahren, umfassend
a) Bereitstellen eines primären Substrats, welches auf mindestens einer Oberfläche mit einer geordneten Anordnung von Metall-Nanopartikeln, die mittels eines Verfahrens der mizellaren Blockcopolymer-Nanolithografie erzeugt wurde, dekoriert ist;
b) Ätzen des primären Substrats von Schritt a) in einer vorbestimmten Tiefe, vorzugsweise im Bereich von 50 bis 500 nm, wobei die Nanopartikel als Maske wirken, und eine geordnete Anordnung von Nanosäulen oder Nanokegeln, welche den Positionen der Nanopartikel entspricht, erzeugt wird;
c) Verwenden des in Schritt b) erhaltenen nanostrukturierten Substrats, welches eine geordnete Anordnung von Nanosäulen oder Nanokegeln umfasst, als Matrize oder Stempel, um eine entsprechende negative Struktur auf einem sekundären Substrat zu erzeugen.

2. Verfahren zur Herstellung von hochgeordneten Nanohole-Strukturen auf einer Substratoberfläche, umfassend
a) Bereitstellen eines primären Substrats, welches auf mindestens einer Oberfläche mit einer geordneten Anordnung von Metall-Nanopartikeln, die mittels eines Verfahrens der mizellaren Blockcopolymer-Nanolithografie erzeugt wurde, dekoriert ist;
b) Ätzen des primären Substrats von Schritt a) in einer vorbestimmten Tiefe, vorzugsweise im Bereich von 50 bis 500 nm, wobei die Nanopartikel als Maske wirken, und eine geordneten Anordnung von Nanosäulen oder Nanokegeln, welche den Positionen der Nanopartikel entspricht, erzeugt wird;
c) Beschichten der in Schritt b) erhaltenen nanostrukturierten Substratoberfläche mit einer kontinuierlichen Metallschicht;
d) selektives Ätzen des Produkts von Schritt c), wobei ein Ätzmittel z.B. HF, verwendet wird, welches das primäre Substrat, jedoch nicht die Metallschicht, entfernt, resultierend in einem Metallsubstrat, das eine geordnete Anordnung von Nanoholes, welche ein Negativ der ursprünglichen Anordnung von Nanosäulen oder Nanokegeln ist, umfasst.

3. Verfahren nach Anspruch 2, wobei die Beschichtung des primären Substrats mit einer kontinuierlichen Metallschicht in Schritt c) bewirkt wird durch i) Aufbringen eines ersten Metallfilms (Saatschicht) durch physikalische Dampfabscheidung (PVD), z. B. Sputtern oder Verdampfung, oder Bindung von Metallkolloiden, ii) Wachsen lassen des Metallfilms durch stromlose Abscheidung oder Elektroplattierung, bis eine vorbestimmte Enddicke der Metallschicht erreicht ist.

4. Verfahren nach Anspruch 2 oder 3, wobei das Metall der Metallschicht aus der Gruppe ausgewählt ist, die aus Ni, Cr oder Legierungen wie Ni-Co besteht.

5. Verfahren nach den Ansprüchen 2-4, welches ferner umfasst die Verwendung des in Schritt d) erhaltenen nanostrukturierten Metallsubstrats, das eine geordnete Anordnung von Nanoholes umfasst, als Matrize oder Stempel zur Bildung einer entsprechenden negativen Struktur auf einem sekundären Substrat durch Nanoimprint-Lithografie (NIL)-, Heißpräge- oder Spritzgussverfahren.

6. Verfahren nach irgendeinem der Ansprüche 1-5, wobei das primäre Substrat aus der Gruppe ausgewählt ist, die aus Gläsern, insbesondere Borsilikatgläsern und Quarzglas, sowie Silicium besteht.

7. Verfahren nach irgendeinem der Ansprüche 1-6, wobei das Ätzen in Schritt b) eine Behandlung des reaktiven Ionenätzens umfasst.

8. Verfahren nach Anspruch 7, wobei das Ätzen in Schritt b) eine Behandlung mit einem Ätzmittel umfasst, welches aus der Gruppe ausgewählt ist, die aus Chlor, gasförmigen Chlorverbindungen, Fluorkohlenwasserstoffen, Fluorkohlenstoffen, Sauerstoff, Argon, SF₆ und Mischungen davon besteht.

9. Verfahren nach irgendeinem der Ansprüche 1-8, wobei die Form der Nanokegel im Wesentlichen derjenigen der Hälfte eines Hyperboloids entspricht.

10. Verfahren nach Anspruch 9, wobei in dem Ätzschritt b) Hyperboloid-Strukturen erzeugt werden und die Nanokegel durch Brechen der Hyperboloid-Strukturen im Bereich ihres kleinsten Durchmessers durch Anwendung mechanischer Kräfte, insbesondere Ultrabeschallung, erzeugt werden.

11. Verfahren nach irgendeinem der Ansprüche 1-10, wobei die Nanopartikel Nanopartikel aus einem Edelmetall, insbesondere Gold, Ni- oder Cr-Nanopartikel sind.

12. Verfahren nach irgendeinem der Ansprüche 1-11, wobei die Nanosäulen oder Nanokegel eine mittlere Distanz von 20 nm bis 400 nm, vorzugsweise von 25 nm bis 300 nm, bevorzugter von 50 nm bis 250 nm, aufweisen.

13. Verfahren nach irgendeinem der Ansprüche 1-12, wobei die endgültige Substratoberfläche, welche während der genannten Nanoimprint-Lithografie (NIL)-, Heißpräge- oder Spritzgussverfahren nanostrukturiert wurde, eine nicht-planare, insbesondere konvexe oder konkave, Oberfläche ist.

14. Verfahren nach einem der Ansprüche 1-13, wobei die endgültige Substratoberfläche, welche während der genannten Nanoimprint-Lithografie (NIL)-, Heißpräge- oder Spritzgussverfahren nanostrukturiert wurde, die Oberfläche eines optischen Elementes, z.B. eines Fensters, einer Linse, einer Mikrolinsenanordnung, einer intraokularen Linse, oder einer Sensorvorrichtung oder einer Komponente einer Solarzelle ist.

## Revendications

1. Procédé de préparation de structures hautement ordonnées de nanotrous sur une surface de substrat par des processus de lithographie par nanoimpression (NIL), de gaufrage à chaud ou de moulage par injection comprenant
a) la fourniture d'un substrat primaire qui est décoré sur au moins une surface avec un tableau ordonné de nanoparticules métalliques produites au moyen d'un processus de nanolithographie à copolymère séquencé micellaire ;
b) la gravure du substrat primaire de l'étape a) selon une profondeur prédéterminée, de préférence dans la plage de 50 à 500 nm, dans lequel les nanoparticules agissent comme un masque et un tableau ordonné de nanopiliers ou de nanocônes correspondant aux positions des nanoparticules est produit ;
c) l'utilisation du substrat nanostructuré obtenu à l'étape b) qui comprend un tableau ordonné de nanopiliers ou de nanocônes en tant que gabarit ou étampe pour produire une structure négative correspondante sur un substrat secondaire.

2. Procédé de préparation de structures hautement ordonnées de nanotrous sur une surface de substrat comprenant
a) la fourniture d'un substrat primaire qui est décoré sur au moins une surface avec un tableau ordonné de nanoparticules métalliques produites au moyen d'un processus de nanolithographie de copolymère séquencé micellaire ;
b) la gravure du substrat primaire de l'étape a) selon une profondeur prédéterminée, de préférence dans la plage de 50 à 500 nm, dans lequel les nanoparticules agissent comme un masque et un tableau ordonné de nanopiliers ou nanocônes correspondant aux positions des nanoparticules est produit ;
c) le revêtement de la surface du substrat nanostructuré obtenu à l'étape b) avec une couche métallique continue ;
d) la gravure sélective du produit de l'étape c) à l'aide d'un agent de gravure, par exemple HF, qui élimine le substrat primaire mais pas la couche métallique, aboutissant à un substrat métallique comprenant un tableau ordonné de nanotrous qui est un négatif du tableau original de nanopiliers ou nanocônes.

3. Procédé selon la revendication 2, dans lequel le revêtement du substrat primaire avec une couche métallique continue à l'étape c) est effectué par i) application d'un film métallique initial (couche d'ensemencement) par dépôt physique en phase vapeur (PVD), par exemple pulvérisation cathodique ou évaporation, ou liaison de colloïdes métalliques, ii) croissance du film métallique par dépôt anélectrolytique ou électroplaquage jusqu'à ce qu'une épaisseur finale prédéterminée de la couche métallique soit atteinte.

4. Procédé selon la revendication 2 ou 3, dans lequel le métal de ladite couche métallique est choisi dans le groupe consistant en Ni, Cr ou des alliages de Ni-Co.

5. Procédé selon les revendications 2 à 4, qui comprend en outre l'utilisation du substrat métallique nanostructuré obtenu à l'étape d) qui comprend un tableau ordonné de nanotrous en tant que gabarit ou étampe pour produire une structure négative correspondante sur un substrat secondaire par des processus de lithographie par nanoimpression (NIL), gaufrage à chaud ou moulage par injection.

6. Procédé selon l'une quelconque des revendications 1 à 5, dans lequel le substrat primaire est choisi dans le groupe consistant en des verres, en particulier des verres de borosilicate et de la silice fondue, et du silicium.

7. Procédé selon l'une quelconque des revendications 1 à 6, dans lequel la gravure à l'étape b) comprend un traitement de gravure par ions réactifs.

8. Procédé selon la revendication 7, dans lequel la gravure à l'étape b) comprend un traitement avec un agent de gravure qui est choisi dans le groupe consistant en le chlore, des composés de chlore gazeux, des fluorohydrocarbures, des fluorocarbones, l'oxygène, l'argon, SF₆, et leurs mélanges.

9. Procédé selon l'une quelconque des revendications 1 à 8, dans lequel la forme des nanocônes correspond essentiellement à une moitié d'un hyperboloïde.

10. Procédé selon la revendication 9, dans lequel à l'étape de gravure b), des structures d'hyperboloïde sont produites et les nanocônes sont produits en cassant lesdites structures d'hyperboloïde dans la région de leur plus petit diamètre par application de forces mécaniques, en particulier d'une ultrasonication.

11. Procédé selon l'une quelconque des revendications 1 à 10, dans lequel les nanoparticules sont des nanoparticules de métal noble, en particulier d'or, de Ni, ou de Cr.

12. Procédé selon l'une quelconque des revendications 1 à 11, dans lequel les nanopiliers ou nanocônes ont une distance moyenne de 20 nm à 400 nm, de préférence de 25 nm à 300 nm, de manière davantage préférée de 50 nm à 250 nm.

13. Procédé selon l'une quelconque des revendications 1 à 12, dans lequel le substrat final nanostructuré en surface pendant lesdits processus de lithographie par nanoimpression (NIL), de gaufrage à chaud ou de moulage par injection est une surface non plane, en particulier convexe ou concave.

14. Procédé selon l'une quelconque des revendications 1 à 13, dans lequel le substrat final nanostructuré en surface pendant lesdits processus de lithographie par nanoimpression (NIL), gaufrage à chaud ou moulage par injection est la surface d'un élément optique, par exemple une fenêtre, une lentille, un tableau de microlentille, une lentille intra-oculaire ou un dispositif de capteur ou un composant d'une pile solaire.
